Europäisches Patentamt

(19) European Patent Office

Office européen des brevets

(11) Publication number: **0 246 514**
**A2**

(12) **EUROPEAN PATENT APPLICATION**

(21) Application number: 87106711.2

(22) Date of filing: 08.05.87

(51) Int. Cl.³: **H 01 L 21/263**

(30) Priority: 16.05.86 US 864177

(43) Date of publication of application:
25.11.87 Bulletin 87/48

(84) Designated Contracting States:
BE DE ES FR GB IT NL

(71) Applicant: AIR PRODUCTS AND CHEMICALS, INC.
P.O. Box 538
Allentown, Pennsylvania 18105(US)

(72) Inventor: Barkanic, John Anthony
220 Deborah Lane
Schnecksville, PA 18078(US)

(72) Inventor: Sellumuthu, Ram
1217B East Maras Street
Allentown, PA 18103(US)

(72) Inventor: Jaccodine, Ralph J.
2955 Linden Court
Allentown, PA 18105(US)

(72) Inventor: Stenger, Harvey Glenn, Jr.
1414 Main Street
Bethlehem, PA 18018(US)

(74) Representative: Kador & Partner
Corneliusstrasse 15
D-8000 München 5(DE)

(54) Deep trench etching of single crystal silicon.

(57) A process is described for the deep trench, anisotropic plasma etching of single crystal silicon through an apertured mask of $SiO_2$ or $Si_3N_4$ using an atmosphere comprising a mixture of $NF_3$, a halofluorocarbon and optionally an inert gas.

EP 0 246 514 A2

FIG. I

Croydon Printing Company Ltd.

DEEP TRENCH ETCHING OF SINGLE CRYSTAL SILICON

## TECHNICAL FIELD

The present invention is directed to plasma etching silicon to produce advanced microelectronic device structures for megabit chip technology. More specifically, the present invention is directed to the plasma etching of deep trenches in single crystal silicon to perform device isolation function, buried capacitor function and additional circuitry placement function in silicon based microelectronic circuitry.

## BACKGROUND OF THE PRIOR ART

With the development of silicon substrate mounted microelectronic circuitry of greater detail and density, traditional wet etching of electronic circuit patterns has become insufficient for high speed, high precision, low cost, component and circuitry fabrication. This drawback of previous modes for fabricating microcircuitry has led to the advent of dry chemical etching. Specifically, the advent of plasma etching with various gaseous etchants has come to the forefront in microelectronic circuitry fabrication.

Typically, dry plasma etching has been utilized to produce circuit patterns through photoresist materials on polysilicon or single crystal silicon, as well as various doped silicon substrates. These circuit patterns require only a shallow etching into the substrate to provide sufficient patterns for appropriate circuit performance. Typically, etch depths in substrates for circuit patterning are obtained at a maximum depth of 0.30 microns. The substrate, during the etching process, is typically overlaid with an apertured mask providing the circuit pattern wherein the mask has a typical depth of 1.0 microns. Because of the relatively shallow depth of the etch necessary for circuit pattern fabrication, the differential selectivity of the mask and the substrate to the etchant does not have to be significantly high. However, with the advent of very dense packed circuitry and goals for increasingly smaller line width of the patterned circuit, it has become necessary to locate circuit patterns and components in a much more closely packed array and to crowd more and more circuits and components on a given surface area of silicon substrate. These advances in microcircuitry lead to new patterning requirements such as the deep trench. These requirements have placed a need on the fabrication industry to provide highly accurate anisotropic etching which enjoys high selectivity and high etching rates.

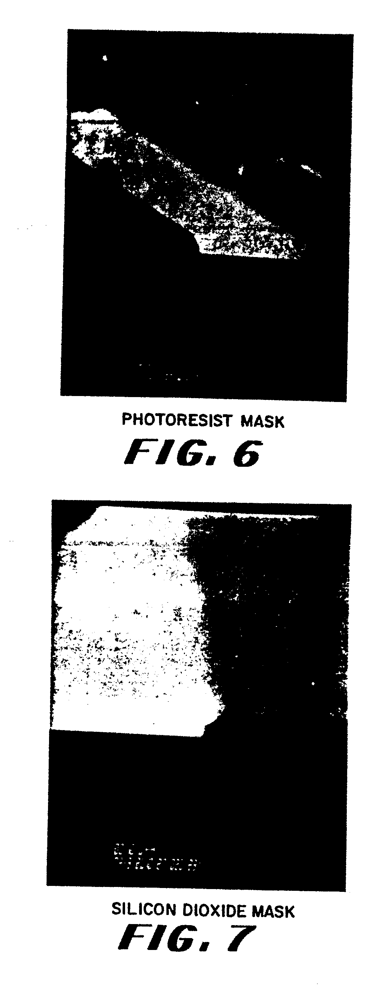

In U.S. Patent 4,473,435, a mode for anisotropic etching of polysilicon with photoresist mask is disclosed wherein sulfur hexafluoride and various halofluorocarbons are the preferred plasma etchants. It is also identified that nitrogen trifluoride can be utilized with various halofluorocarbons to provide the anisotropic etch medium. The etch depth in this patented process is clearly shown in Figures 6 through 14 to be approximately 0.3 microns. The etch depth is not in the range of deep trench etching given the known thicknesses of polymeric photoresist that can be applied to silicon substrates.

Trench etching has been addressed in the prior art in the article, "Anisotropic Etching of Silicon Using $SF_6$ With $C_2ClF_5$ and Other Mixed Halocarbons", by James P. McVittie and Carlos Gonzolez, wherein the article describes the use of sulfur hexafluoride and various halofluorocarbons to etch deep grooves in single crystal silicon using a photoresist mask. The trenches that were etched in the McVittie work had a vertical depth of from 0.5-10 microns. The etch profile was found to occur with reduced undercut using etchant compositions only in the presence of resist. Further, McVittie identifies that some mask undercutting occurred as identified at page 561 of that article. McVittie, et al. has used the preferred embodiment of U.S. Patent 4,473,435 and, as shown on pages 566 and 567, has not been able to etch deep trenches into single crystal silicon without undercut and bow. The bow is objectionable for device placement applications and is present even under the McVittie, et al.'s optimal conditions.

The problems of dry etching and their capabilities have been identified in the prior art such as the article "Loading Effect and Temperature Dependence of Etch Rate of Silicon Materials in $CF_4$ Plasma" by Tatsuya Enomoto, appearing in Solid State Technology of April 1980, page 117, wherein the effects of carbon tetrafluoride plasma etching of

- 3 -

single crystal silicon and polysilicon substrates is identified. Enomoto discloses that polysilicon is etched more quickly than single crystal silicon for a given exposure area. In addition, Mr. Enomoto discloses the physical phenomena occurring in plasma etching wherein undercutting occurs under the apertured mask of the silicon substrate being fabricated.

The prior art recited above has identified various techniques for typical electronic circuit pattern etching which is done typically at depths of less than 0.30 microns. The initial descriptions of anisotropic dry plasma etching have also been disclosed, as well as suggestions for deep trench etching wherein the problems of anisotropy and etch rate have been identified. However, the problems of complete anisotropy, precision, fast etching and economical fabrication of deep trenches have not been resolved by the prior art. The present invention overcomes these problems for high speed, economical, anisotropic, deep trench etching without profile bowing or mask undercut.

## BRIEF SUMMARY OF THE INVENTION

The present invention is a process for high speed, anisotropically, reactive ion mode plasma etching of single crystal silicon through an apertured mask to produce a deep trench with essentially vertical sidewalls comprising the steps of providing the single crystal silicon substrate with an apertured mask selected from the group consisting of silicon dioxide and silicon nitride, exposing said substrate to an atmosphere of nitrogen trifluoride ($NF_3$) and a halofluorocarbon compound (HFC) containing only one carbon atom in a ratio of 1-2 $NF_3$:1-3 HFC in an etching zone, and generating a plasma with the atmosphere and anisotropically reactive ion etching said substrate by directing ions from said plasma through the apertures of said mask into the single crystal silicon substrate, wherein the etching is performed at a high speed in the range of at least 0.1 microns per minute using a power of 500-2000 watts and a frequency of 1-50 MHz to produce a deep trench in said substrate having a vertical depth in the range of 3-15 microns and essentially vertical sidewalls, essentially no undercutting of said mask and essentially no bowing in the trench.

Preferably, the process of the present invention is practiced wherein the halofluorocarbon is selected from the group consisting of $CF_3Cl$, $CF_2Cl_2$, $CF_3Br$, $CF_3I$, $CF_2Br_2$, $CF_2I_2$, $CF_2ClH$ and $CCl_2FH$.

Optimally, the process of the present invention utilizes an atmosphere comprising $NF_3$ and $CF_3Cl$.

Preferably, the process of the present invention maintains a pressure in the etching zone of greater than 0.1 and up to 1.0 torr.

Optimally, the process of the present invention utilizes an apertured mask of silicon dioxide.

Preferably, the process of the present invention utilizes a flow of the etchant atmosphere in the etching zone in the range of 10-100 standard cubic centimeters per minute (SCCM).

Preferably, the process of the present invention utilizes spaced electrodes in the etch zone which are maintained at a temperature of 15-25°C.

Preferably, the process of the present invention utilizes a diluent gas selected from the group consisting of argon, krypton, helium and neon.

## BRIEF DESCRIPTION OF THE DRAWINGS

FIG 1 is a schematic flowscheme of an etching zone wherein the plasma etching composition of the present invention can be utilized to produce a deep trench in a silicon substrate.

FIG 2 is a cross-sectional illustration of an etch pattern in the silicon substrate of the prior art wherein undercutting of the mask is illustrated, as well as bowing of the trench itself.

FIG 3 is a cross-sectional illustration of an apertured mask on a silicon substrate prior to etching.

FIG 4 is a cross-sectional illustration of a deep trench etch by the process of the present invention using a silicon dioxide apertured mask and a single crystal silicon substrate.

FIG 5 is a graph illustrating the higher etch rate of polysilicon versus single crystal silicon using the known etching gas of carbon tetrafluoride.

FIG 6 is a cross-sectional photomicrograph of an etch using the etch medium of the present invention to etch single crystal silicon through an apertured photoresist mask.

FIG 7 is a cross-sectional photomicrograph of an etch using the etch medium of the present invention through an apertured mask of silicon dioxide.

FIG 8 is a cross-sectional photomicrograph of the deep trench etch using the process of the present invention.

DETAILED DESCRIPTION OF THE INVENTION

At many points in the manufacture of semiconductor chips, a semiconductor wafer is etched in a pattern defined by the apertures of an overlying mask. Plasma etching of several of the layers of thin films on semiconductor wafers is used as a more effective alternative to wet chemical etching. The specific thin film layer deposited or grown on the semiconductor wafer to be plasma etched is typically covered with an apertured mask and placed in a gaseous environment. The gases directly above the wafer are ionized by RF energy to create a plasma and ions are accelerated out of the plasma to impact the semiconductor wafer. Etching of the portions of the thin film exposed through the mask apertures is accomplished as a function of the reactivity of the substrate material, the impact energy of the bombarding ions, and the chemical activity of the gaseous environment.

The anisotropic etching of silicon is becoming increasingly important as device sizes shrink. Small dimensions are making etch losses and etch geometries more critical. Directional etching of single crystal silicon with tightly controlled etch profiles is of extreme importance for various advanced applications such as circuit isolation, capacitor formation and vertical component location distinct from component location on the primary surface of the second substrate. Previously, the fabrication industry has performed anisotropic etching of silicon for deep trenches using chlorine-based chemistry and conventional low pressure reactive ion etch modes. However, difficulties have arisen in performing significantly deep trench etching for such purposes. The problem presently facing semiconductor fabricators is to produce completely vertical, anisotropic wall profiles using plasma assisted etching wherein the etching of the electronic materials vertically must be done with rapid plasma chemistry to maintain high throughput and reduced microchip costs. The use of specific etchant mixtures on specific substrates using specific apertured masks for the deep trench pattern has become necessary and the combination of these critical features provides the unique opportunity to overcome the problems of deep trench etching with highly reproducible results as identified by the process of the present invention.

Various highly reactive fluorine-containing etchants are known in the prior art such as nitrogen trifluoride and sulfur hexafluoride. However, these highly reactive etchants produce high speed etch rates in isotropic fashion. Isotropic etching is defined as etching in approximately equal rates in all directions. The result of isotropic etching is undercutting and bowing of etch patterns under the aperture of a mask applied to a substrate. The result of the use of such fluorine compounds individually is illustrated in FIG 2 wherein undercutting is identified in which the pattern cuts back underneath the mask of the silicon substrate and bowing in the sidewalls occurs as identified between the furthest horizontal penetration of the etch and the least penetration of the etch at the point of mask substrate interface.

Alternatively, anisotropic etching, that is etching wherein the etch occurs in only one direction, preferably an etch directly down through the aperture of the mask formed over the silicon substrate, has been experienced with halofluorocarbon etchants. However, the halofluorocarbon etchants have been relatively slow in etching typical silicon substrates and therefore do not lend themselves to the high speed, low cost fabrication required in present day economies of microcircuit and semiconductor fabrication.

The present invention combines the use of nitrogen trifluoride and halofluorocarbons to arrive at high speed etching with anisotropic etch patterns with substantially or essentially no undercutting or bowing in the etch pattern wherein the halofluorocarbon is typically selected from the group comprising $CF_3Cl$, $CF_2Cl_2$, $CF_3Br$, $CF_3I$, $CF_2Br_2$, $CF_2I_2$, $CF_2ClH$ and $CCl_2FH$. The preferred plasma etch combination constituting the etchant atmosphere is a combination of $NF_3$ and $CF_3Cl$. The present invention uses customized reactive ion mode etching which involves higher pressures to circumvent the surface damage and etch rate problems outlined in the McVittie, et al. article at page 552. This customized mode of etching combined with the reactive gas chemistry are required to obtain the desired results. The $NF_3$ of the plasma atmosphere of the present invention provides the rapid etch rate required and the high silicon over silicon dioxide selectivity required to minimize mask erosion and etch undercut. This contrasts with $SF_6$, which typically has lower etch rates and selectivities. The halofluorocarbon gas component of the present invention's atmosphere is limited to those gases having only one carbon atom and at least one halogen atom other than fluorine in order that the halofluorocarbon gas results in the formation of a tenacious passivating polymer obtained through a difluorocarbene mechanism which is deemed necessary for anisotropy observed in the method of the present invention under reactive ion mode plasma etching. It has been found that this gaseous etching atmosphere when used on a single crystal silicon substrate with an apertured mask of preferably silicon dioxide, or alternatively, silicon nitride, provides the capability of anisotropic deep trench etching wherein the trench may be etched to a depth of 3-15 microns. The etch medium may utilize an inert carrier gas, such as argon, krypton, helium or neon. Preferably, the nitrogen trifluoride and the halofluorocarbon compound are used in a ratio of 1:2 nitrogen trifluoride per 1:3 of the halofluorocarbon in the etch atmosphere. The etch is usually performed at a high speed at the range of at least 0.1 microns per minute up to 2.0 microns per minute. The power of the etch system is in the range of 500-2000 watts using a frequency of 1-50 MHz. The flow rate of the etchant atmosphere through the etching zone is in the range of 10-100 standard cubic centimeters per minute (SCCM). The pressure in the etching zone is maintained in a vacuum condition of 0.01-1 TORR. The electrode temperature of the etching zone apparatus is maintained in the range of 15-25°C. The etching technique, although generically referred to as plasma etching, is more specifically a reactive ion mode of etching using a plasma. The reactive ion mode is differentiated by the requirement that the substrate be mounted on the powered electrode. Reactive ion mode is necessary to achieve the anisotropic results desired for deep trench etching.

A comparison of the prior art sulfur hexafluoride systems with the system of the present invention is set forth in Table 1. As can be seen, the etch rates of the present invention are commensurate with those of the prior art while maintaining similar etch depths, but entirely avoiding the undercut which is particularly difficult to avoid in deep trench etching. The sulfur hexafluoride runs are reported from the McVittie, et al. article cited above.

## T A B L E   1

### COMPARISON OF RESULTS

| Gas Mixture | Etch Rate ($\mu$m/min) | Etch Depth ($\mu$m) | Undercut ($\mu$m) | Ref. |
|---|---|---|---|---|
| $C_2F_5Cl-SF_6$ | 0.51 | ~6.0 | * | McVittie, et al. |
| $CF_3Br-SF_6$ | 0.51 | ~6.0 | 0.35 | McVittie, et al. |
| $CFCl_3-SF_6$ | 0.26 | ~6.0 | * | McVittie, et al. |
| $CF_2Cl_2-SF_6$ | 0.16 | ~6.0 | * | McVittie, et al. |
| $65\%CF_3Cl-NF_3$ | 0.40 | 4.0 | 0[t] | Present Invention |
| $50\%CF_2Cl_2-NF_3$ | 0.50 | 5.0 | 0[t] | Present Invention |
| $40\%CF_3Br-NF_3$ | 0.60 | 6.0 | 0[t] | Present Invention |

* Values were not reported, but photomicrographs show similar undercutting.

[t] Values are accurate to less than 0.1 $\mu$m deviation.

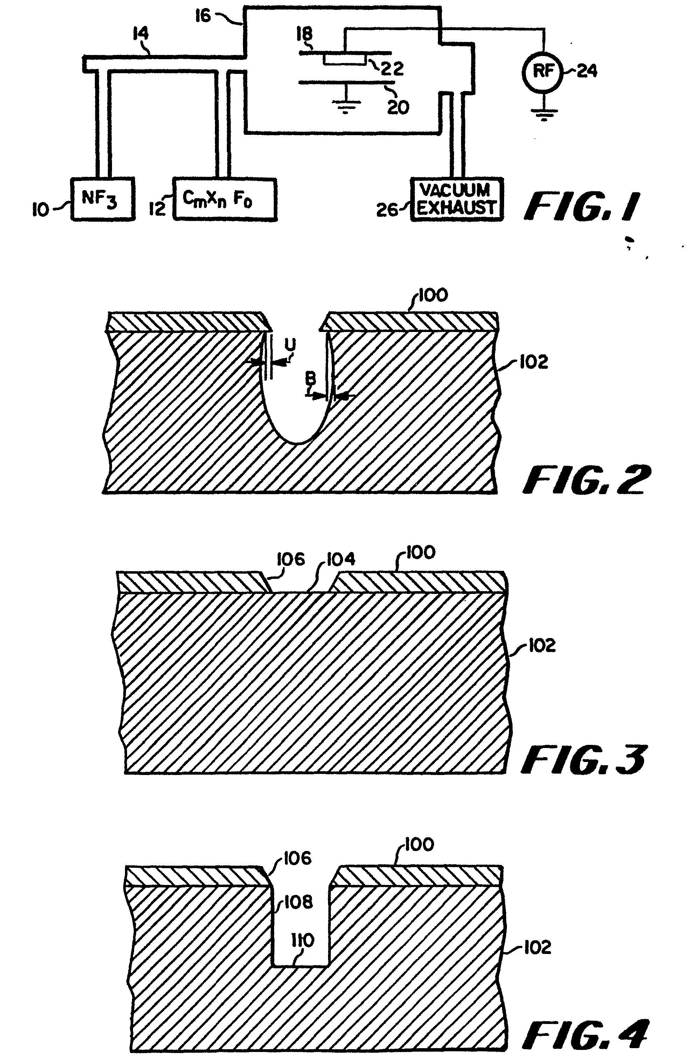

With reference to FIG 1, a description of the system for performing deep trench etching with plasma etchants of the present invention will now be described. $NF_3$ is stored in a gas containment 10 for admixture with a halofluorocarbon contained in containment 12. The materials in the gaseous state are blended in manifold 14 and introduced at appropriate flow rate into the etching zone 16 wherein two parallel plate electrodes 18 and 20 are situated. The silicon dioxide or silicon nitride apertured mask/single crystal silicon 22 which is to be deep trench etched is mounted on the powered electrode 18 and an RF current at the appropriate power and frequency is provided from source 24. The gas mixture of $NF_3$ and halofluorocarbon in conjunction with an optional inert carrier gas flows through the etching zone 16 and produces a plasma in conjunction with the current potential between the electrodes 18 and 20. The electric potential induces ions from the created plasma to etch the appropriate deep trench in the single crystal silicon in the pattern provided by the apertured mask. Etching by-products, plasma material and excess etching atmosphere are removed through a vacuum exhaust system 26. The entire system is also maintained under a vacuum.

FIG 2 illustrates an etched silicon substrate 102 with its overlying mask 100. The dimension by which the trench recedes back from the lower interface and edge of the mask aperture is referred to as undercut and is identified by the letter "U". Undercut is an undesireable result of etching with less than anisotropic procedures. It results in lost pattern definition. Bowing is shown as the variation in the trench sidewall from absolute vertical. It is identified as the letter "B". It is also undesireable and interferes with CVD processing.

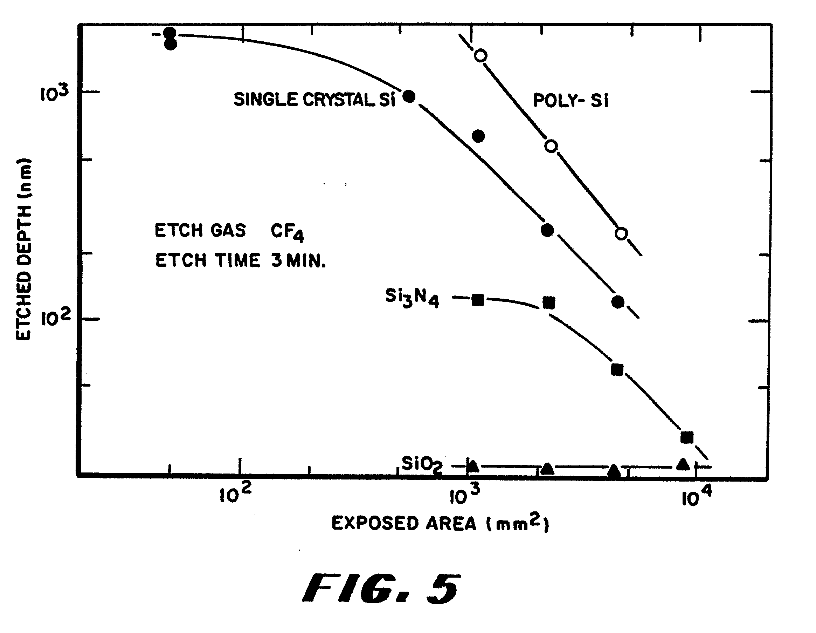

FIG 3 illustrates the single crystal silicon 102 used in the present invention which is masked with the preferred silicon dioxide mask 100 in a thickness of approximately 1 micron prior to etching with the process of the present invention. It shows an aperture 104 with edge 106. In contrast, FIG 4 shows the deep trench etch 110 in the substrate 102 using the preferred etchants of the present invention wherein the aperture of the silicon dioxide mask is relatively intact with good edges 106 and the deep trench profile 108, which is approximately 4 microns deep, shows essentially no undercutting and essentially no bowing, such as is required in the fabrication specifications of advanced semiconductor device structures.

Such anisotropic deep trench etching is experienced only in the precision fabrication manner described above when single crystal silicon is utilized with either silicon dioxide or silicon nitride masks. As illustrated in FIG 5, showing a graph of the etch rates for another etch medium, carbon tetrafluoride, alternate substrates such as polysilicon are known to etch at a much higher rate than single crystal silicon. Therefore, selectivity of silicon over silicon dioxide would be expected to be lower when using single crystal silicon and aperture mask erosion more probable. This is detrimental for deep trench etching, except with the unexpected results of the present invention.

The effects of the masking material are shown by comparison of FIG 6 and FIG 7 which are actual photomicrographs of etching of single crystal silicon with the etch mediums of the present invention wherein the etching conditions constituted 30% $CF_3Cl$, 15% $NF_3$ in argon at 1000 watts cathode mounted at 135 millitorr and 20 SCCM etch rate. FIG 6 shows that photoresist as a masking agent over the single crystal silicon results in substantial loss of edge pattern in the aperture of the mask and resulting degradation in the vertical profile of the trench. In contrast, FIG 7 shows that a silicon dioxide mask over a single crystal silicon substrate does not erode under reactive ion mode plasma etching conditions to a significant degree, leaving a substantially or essentially vertical sidewall to the trench produced by reactive ion mode plasma etching in the single crystal silicon substrate. It is also of interest to note that the thickness of masking agent has been significantly eroded in the photoresist mask example of FIG 6, while the depth of silicon dioxide mask remains intact in the example illustrated in FIG 7.

The substantially or essentially vertical sidewall which means essentially no undercut or bowing is defined as less than 0.1 micron deviation from an absolute vertical sidewall and flush meeting of the mask edge and the substrate edge at the mask-substrate interface.

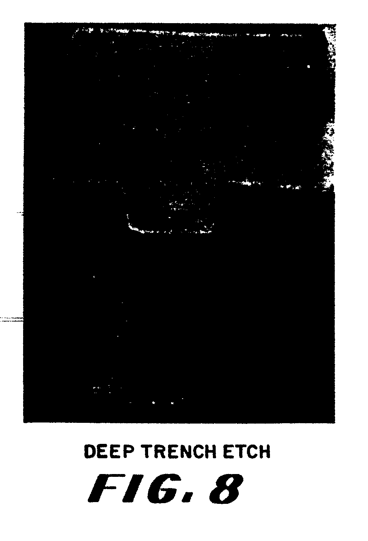

FIG 8 is a photomicrograph of the cross-section of a deep trench etch of single crystal silicon with an apertured mask of silicon dioxide using a plasma etching atmosphere of 10% argon, 30% $NF_3$ and 60% $CF_3Cl$. This deep trench using the process of the present invention was achieved under the conditions of the following example.

## WORKING EXAMPLE

The wafer samples of single crystal silicon patterned with an apertured mask of one micron thick thermally grown silicon dioxide were placed on the reactor cathode. The parallel plate etching chamber was then closed and evacuated to 0.001 torr. The gases were then independently metered into a mixing manifold and then passed into the plasma reactor. Gas flowrates were 12, 6 and 2 SCCM for $CF_3Cl$, $NF_3$ and argon, respectively. These flows represented a gas mixture consisting of 60% $CF_3Cl$, 30% $NF_3$ and 10% argon. The reactor was allowed to equilibrate to a constant pressure of 0.140 torr. The electrode temperatures were maintained constant at 17°C. Power was then applied to the cathode electrode in the amount of 1000 watts and a plasma ambient was created for reactive ion etching. The etching process continued for 10 minutes at which time the power was turned off. The flow of gases was then stopped, the chamber was evacuated, filled with nitrogen to one atmosphere and the wafers of etched single crystal silicon were removed. The anisotropy and etch rate were then determined using scanning electron microscopy. The result from the experiment, shown in Figure 8, was a deep, completely anisotropic trench in single crystal silicon obtained at an etch rate of 0.4 micron per minute.

Similar experiments were performed, changing only the halofluorocarbon and the gas composition, using $CF_2Cl_2$ and $CF_3Br$ with similar experimental results achieved, as identified in Table 1 above.

As identified above, the process of the present invention using nitrogen trifluoride and halofluorocarbon plasma etchants in an atmosphere to etch single crystal silicon through a silicon dioxide or silicon nitride apertured mask is effective for producing anisotropic deep trench etches of a depth and profile previously difficult to produce. These deep trenches have essentially anisotropic profile wherein there is no undercutting and no bowing. In contrast to the prior art which used sulfur hexafluoride or nitrogen trifluoride and various halofluorocarbons with photoresist mask in polysilicon at normal etch depths for circuit patterns of 0.30 microns, the requirements of deep trench etching aggravate all parameters of high speed, high precision, anisotropic etch fabrication. It has been shown that polysilicon etches in the distinctly different manner than the single crystal silicon and particularly at a much higher etch rate which is a condition which would aggravate anisotropic etching over the periods necessary to develop 3-15 micron deep trenches. It has also been shown that the polymeric photoresist masks utilized by the prior art do not have a sufficient selectivity with regard to their substrate to endure the rigorous conditions of deep trench etching. It has been surprisingly found by the present inventors that a unique solution to the problem of deep trench etching to arrive at anisotropic profile is derived by the use of nitrogen trifluoride, which has an extremely high etch rate, with various halofluorocarbons in a high pressure reactive ion mode etch process. The novel process has high anisotropic characteristics, using a relatively inert silicon dioxide mask on a single crystal silicon substrate. The silicon dioxide and the single crystal silicon exhibit the appropriately necessary, highly selective etch differential for the chosen etch medium to produce an anisotropic deep trench etch appropriate for circuit isolation technology, capacitor formation or electronic component location deemed necessary for the advancing miniaturization in semiconductor and microelectronic fabrication. Only this unique combination of etchant mixtures, apertured mask, silicon substrate and high pressure reactive ion mode etch provides the unique solution to the deep trench etching problem.

The present invention minimizes any undercut. At similar magnifications of similar trench depths to McVittie, et al., the photomicrographs of the present invention show essentially no undercut, while the McVittie, et al. photomicrographs show visible undercut, which in at least one case was identified by its author as being of the dimension of 0.35 microns.

Although the present invention has been described with reference to a preferred embodiment, the scope of the invention should not be limited to that embodiment, but rather should be ascertained from the claims which follow:

## CLAIMS

1. A process for high speed, anisotropically, reactive ion mode plasma etching of single crystal silicon through an apertured mask to produce a deep trench with essentially vertical sidewalls comprising the steps of:

(a) providing a single crystal silicon substrate with an apertured mask selected from the group consisting of silicon dioxide and silicon nitride;

(b) exposing said substrate to an atmosphere of nitrogen trifluoride ($NF_3$) and a halofluorocarbon (HFC) compound containing only one carbon atom in a ratio of 1 to 2 $NF_3$:1 to 3 HFC in an etching zone; and

(c) generating a plasma with the atmosphere and anisotropically reactive ion etching said substrate by directing ions from said plasma through the apertures of said mask into the single crystal silicon substrate, wherein the etching is performed at a high speed in the range of at least 0.1 micron per minute using a power of 500-2000 watts and a frequency of 1-50 MHz to produce a deep trench in said substrate having a vertical depth in the range of 3-15 microns and essentially vertical sidewalls, essentially no undercutting of said mask and essentially no bowing in the trench.

2. The process of Claim 1 wherein the halofluorocarbon is selected from the group consisting of $CF_3Cl$, $CF_2Cl_2$, $CF_3Br$, $CF_3I$, $CF_2Br_2$, $CF_2I_2$, $CF_3ClH$ and $CCl_2FH$.

3. The process of Claim 1 wherein the atmosphere comprises $NF_3$ and $CF_3Cl$.

4. The process of Claim 1 wherein the etching zone during the etching is maintained at a pressure of greater than 0.1 and up to 1.0 TORR.

5. The process of Claim 1 wherein the apertured mask is $SiO_2$.

6. The process of Claim 1 wherein the flow of the atmosphere in the etching zone is 10-100 SCCM.

7. The process of Claim 1 wherein the etch zone includes spaced electrodes which are maintained at a temperature of 15-25°C.

8. The process of Claim 1 wherein said atmosphere includes a diluent gas selected from the group consisting of argon, krypton, helium or neon.

FIG. 1

FIG. 2

FIG. 3

FIG. 4

FIG. 5

PHOTORESIST MASK

*FIG. 6*

SILICON DIOXIDE MASK

*FIG. 7*

DEEP TRENCH ETCH
## FIG. 8